# EUROPEAN PATENT APPLICATION

(11) **EP 4 841 633 A1**
(43) Date of publication of application: **18.11.2026**
(21) Application number: 25214838.2
(22) Date of filing: 11.11.2025
(51) Int. Cl.: G11C 11/16, G11C 13/00

(54) **MEMORY STRUCTURE WITH MEMORY CELLS IN DIFFERENT SECTIONS OF THE SAME COLUMN CONNECTED TO DIFFERENT SOURCE LINES**

(30) Priority: 12.05.2025 US 202519205649
(71) Applicant: GlobalFoundries U.S. Inc., Malta, NY 12020 (US)
(72) Inventor: ANDRE, Thomas W., Saratoga Springs (US); NANJUNDEGOWDA, Sathisha, Bangalore (IN); CHINTHU, Siva Kumar, Bangalore (IN)
(74) Representative: Grünecker Patent- und Rechtsanwälte PartG mbB

(57) **Abstract**

Disclosed are a memory structure and associated operating method. The structure includes: an array of memory cells in columns and rows; and, for each column, a bit line (BL) and multiple source lines (SLs). The BL is connected to all memory cells in the column, whereas each SL is connected to all memory cells in a corresponding section of the column. During a memory operation directed to a selected memory cell within a column, the SL connected to the selected memory cell and to all unselected memory cells within the same section of the column can be biased to an operation-dependent source line voltage level and the SLs connected to the unselected memory cells in all other sections of the same column can be biased to a different source line voltage level to minimize leakage current through at least some unselected memory cells.

## Description

### BACKGROUND

The present disclosure relates to non-volatile memory (NVM) structures, such as resistive random access memory (RRAM) structures and, more particularly, to embodiments of a NVM structure (e.g., a RRAM structure) and an operating method.

Benefits of currently available NVM structures (e.g., RRAM structures) include relatively fast read and write speeds and relatively low power consumption. To be competitive in terms of area efficiency, these NVM structures often include a large array of memory cells (e.g., 512 rows and 4864 columns). Some currently available NVM structures, such as RRAM structures, may however exhibit a significant amount of bit line (BL)-source line (SL) leakage current during memory operations. For example, within an RRAM array, all RRAM cells in the same row are connected to the same word line (WL) for that row and all RRAM cells in the same column are connected to the same bit line (BL) and the same source line (SL) for that column. During a post-manufacture forming operation directed to a selected RRAM cell in the array, the WL voltage (VWL) on the WL for the row containing the selected RRAM can be positive, while the VWLs on WLs for all other rows can be at 0.0V. The BL voltage (VBL) on the BL for a column containing the selected RRAM cell can be positive, relatively high, and higher than the VWL, while the VBLs for all other columns can be at 0.0V. Finally, the SL voltages (VSLs) on all SLs for all columns can be at 0.0V. Thus, a relatively large BL-SL voltage differential is seen across the transistors of any unselected RRAM cells that are in the same column as the selected RRAM cell. Depending upon the technology node, this relatively high voltage differential may result in significant leakage current through those transistors (e.g., through the transistors of 511 unselected RRAM array in the same column as the selected RRAM cell) and may also reduce the life expectancy of the transistors due to time dependent dielectric breakdown (TDDB). For example, the magnitude of the leakage current through the transistor drain and source may be relatively high for a fully depleted silicon-on-insulator (FDSOI) device as compared to a bulk semiconductor device. This is because, in a bulk semiconductor device, some leakage (such as gate induced drain leakage (GIDL)) flows to the semiconductor substrate, whereas in an FDSOI device it does not.

### SUMMARY

Disclosed herein are embodiments of a memory structure. Generally, the memory structure can include an array of memory cells in columns and rows. The memory structure can further include, for each column of memory cells in the array, a bit line for the column and source lines for different sections of the column. The bit line for the column can be connected to all memory cells in that column. Each source line (of the multiple source lines) for the column can be connected to all memory cells in a corresponding section of the column.

In some embodiments, the memory structure can be an RRAM structure. That is, the memory structure can include an array of memory cells in columns and rows. The memory cells can be RRAM cells. The memory structure can further include, for each column of memory cells in the array, a bit line for the column and source lines for different sections of the column. The bit line for the column can be connected to all memory cells in that column. Each source line (of the multiple source lines) for the column can be connected to all memory cells in a corresponding section of the column.

Also disclosed herein are embodiments of a memory structure operating method. The method can include providing a memory structure, as described above. That is, the memory structure can include an array of memory cells in columns and rows. The memory structure can further include, for each column of memory cells in the array, a bit line for the column and source lines for different sections of the column. The bit line for the column can be connected to all memory cells in that column. Each source line (of the multiple source lines) for the column can be connected to all memory cells in a corresponding section of the column. The method can further include performing a memory operation directed to a selected memory cell in one of the columns. Performance of the memory operation can include biasing the source line for the section of the column that contains the selected memory cell differently than other source lines for other sections of the column.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1A is a schematic diagram illustrating a disclosed embodiment of a memory structure;
FIG. 1B is a schematic diagram illustrating another disclosed embodiment of a memory structure;
FIG. 2 is a plan diagram highlighting source line group locations within the memory structure of FIG. 1A or 1B;
FIGs. 3A-3D include a flow diagram illustrating methods of operating the memory structure of FIG. 1A or 1B;
FIG. 4 is a table illustrating an example of biasing conditions that can be employed during different memory operation in an RRAM structure configured as illustrated in FIG. 1A or 1B;
FIG. 5A is a schematic diagram illustrating an example of a source line voltage generation circuit that can be incorporated into the memory structure of FIG. 1A or 1B; and
FIG. 5B is a table illustrating examples of operation-dependent control signals and resulting source line voltages output from the source line voltage generation circuit of FIG. 5A.

### DETAILED DESCRIPTION

As mentioned above, currently available non-volatile memory (NVM) structures, such as resistive random access memory (RRAM) structures, may exhibit a significant amount of bit line (BL)-source line (SL) leakage current during some memory operations. For example, within an RRAM array, all RRAM cells in the same row are connected to the same word line (WL) for that row and all RRAM cells in the same column are connected to the same bit line (BL) and the same source line (SL) for that column. During a post-manufacture forming operation directed to a selected RRAM cell in the array, the WL voltage (VWL) on the WL for the row containing the selected RRAM can be positive, while the VWLs on WLs for all other rows can be at 0.0V. The BL voltage (VBL) on the BL for a column containing the selected RRAM cell can be positive, relatively high, and higher than the VWL, while the VBLs for all other columns can be at 0.0V. Finally, the SL voltages (VSLs) on all SLs for all columns can be at 0.0V. Thus, a relatively large BL-SL voltage differential is seen across the transistors of any unselected RRAM cells that are in the same column as the selected RRAM cell. Depending upon the technology node, this relatively high voltage differential may result in significant leakage current through those transistors (e.g., through the transistors of 511 unselected RRAM array in the same column as the selected RRAM cell) and may also reduce the life expectancy of the transistors due to time dependent dielectric breakdown (TDDB). For example, the magnitude of the leakage current through the transistor drain and source may be relatively high for a fully depleted silicon-on-insulator (FDSOI) device as compared to a bulk semiconductor device. This is because, in a bulk semiconductor device, some leakage (such as gate induced drain leakage (GIDL)) flows to the semiconductor substrate, whereas in an FDSOI device it does not.

In view of the foregoing, disclosed herein are embodiments of a non-volatile memory (NVM) structure (e.g., a resistive random access memory (RRAM) structure) and embodiments of an associated operating method. Specifically, the structure can include: an array of memory cells (e.g., NVM cells, such as RRAM cells) in columns and rows; and, for each column, a bit line (BL) and multiple source lines (SLs). The BL can be connected to all memory cells in the column, whereas each SL can be connected to all memory cells in a corresponding section of the column. With this configuration, during a memory operation directed to a selected memory cell within the column, the SL connected to the selected memory cell and further to all unselected memory cells within the same section of the column can be biased to an operation-dependent source line voltage level. The SLs connected to the unselected memory cells in all other sections of the same column can be biased to a different source line voltage level to minimize BL-SL leakage current through at least some unselected memory cells. In some embodiments of the memory structure, BLs for the columns can be grouped into BL groups and word lines (WLs) for the rows can be grouped into WL groups. Furthermore, the various SLs within the entire array can be grouped into SL groups such that each SL group includes all SLs within an intersecting area between one BL group and one WL group. The SLs in each SL group can be connected to a corresponding, independently operable SL driver. With this configuration, all SLs in a specific SL group (namely the SL group containing the SL connected to a selected memory cell) can be concurrently biased to the same operation-dependent source line voltage level and the source lines in all other SL groups can be biased to different source line voltage levels, which vary depending upon both the memory operation at issue and the location of the SL group relative to the specific SL group. By employing different source line voltages in different source lines across the array, BL-SL leakage current through at least some unselected memory cells (particularly during high voltage memory operations) can be limited and, thus, any operation-dependent reduction in life expectancy of memory cell transistors (e.g., due to TDDB) is also limited.

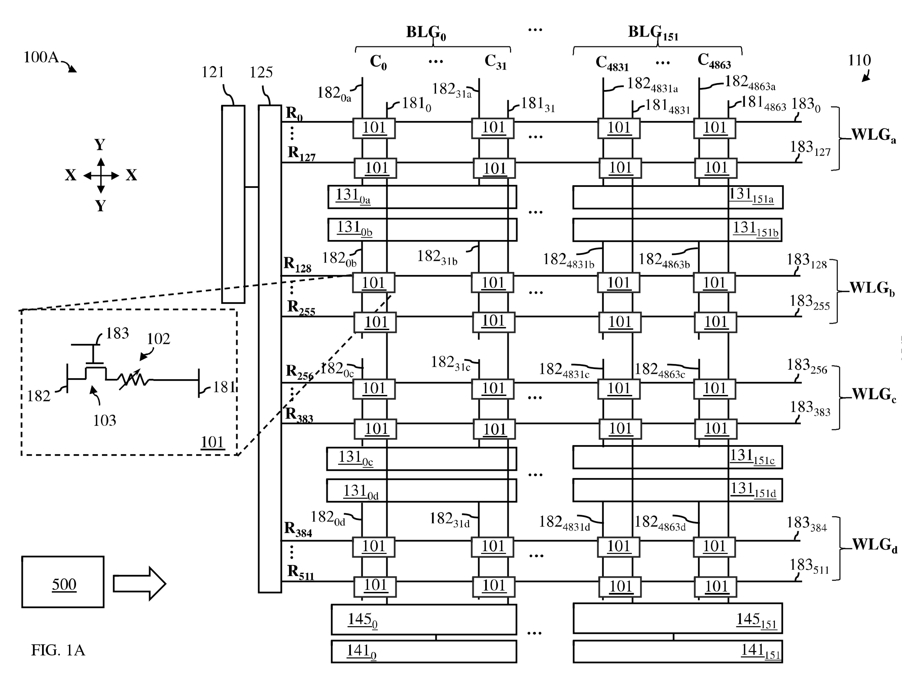

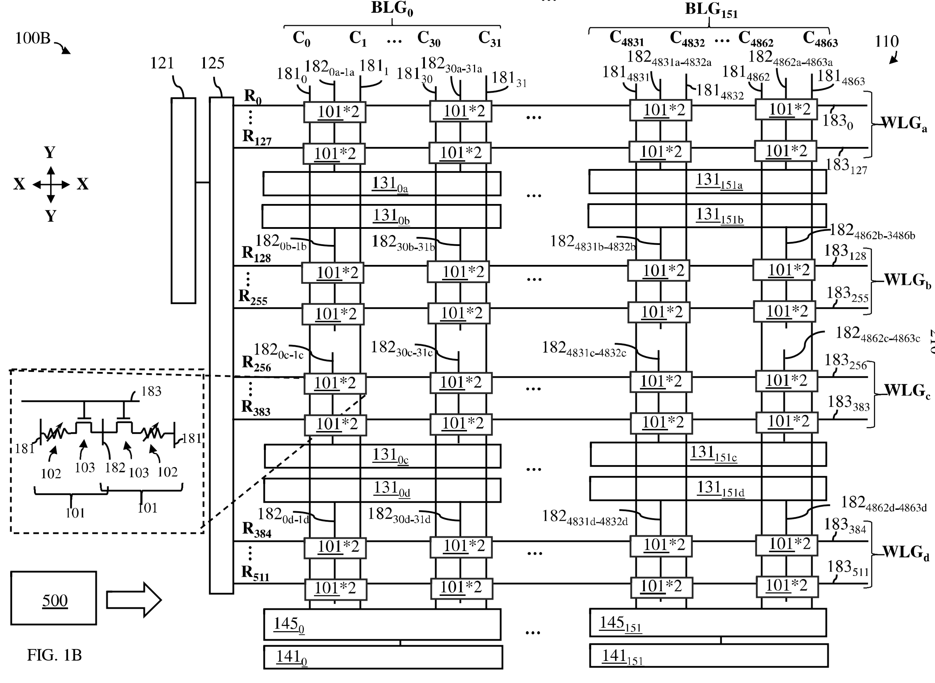

More particularly, FIGs.1A and 1B are schematic diagrams illustrating disclosed embodiments of a memory structure 100A and 100B. Memory structure 100A, 100B can include an array 110 of memory cells 101.

Memory cells 101 within array 110 can be non-volatile memory (NVM) cells, such as resistance-programmable non-volatile memory (NVM) cells. For example, each memory cell 101 can include a programmable resistor 102 (also referred to herein as a variable resistor) and an access transistor 103.

Programmable resistor 102 can be any type of programmable resistor suitable for use in a resistance-programmable NVM cell. For example, in some embodiments, programmable resistor 102 in each memory cell 101 could be a resistive random access memory (RRAM)-type programmable resistor (e.g., a memristor) such that the memory cells 101 are RRAM cells and the memory structure 100A, 100B is an RRAM structure. Alternatively, the programmable resistor 102 could be a magnetic tunnel junction (MTJ)-type programmable resistor such that the memory cells 101 are magnetic random access memory (MRAM) cells and the memory structure 100A, 100B is an MRAM structure. Alternatively, the programmable resistor 102 could be a phase change memory (PCM)-type programmable resistor such that the memory cells 101 are PCM cells and the memory structure 100A, 100B is a PCM structure. Various different configurations for such programmable resistors (e.g., RRAM-type programmable resistors, MTJ-type programmable resistors, PCM-type programmable resistors, etc.) are known in the art and, thus, the specific details thereof have been omitted from this specification to allow the reader to focus on the salient aspects of the disclosed memory structure.

For purposes of illustration, memory structure 100A, 100B is described in greater detail below as an RRAM structure. It should be understood that this description is not intended to be limiting. Generally, those skilled in the art will recognize that an RRAM-type programmable resistor (e.g., a memristor) is typically a back end of the line (BEOL) multi-layer structure, which includes two metal layers separated by a dielectric layer (e.g., hafnium oxide (HfOₓ) or some other suitable oxide layer, also referred to as a switching layer). Depending upon the biasing conditions on the resistor terminals, ions in the dielectric layer may migrate to: (a) break-up a conductive filament in the dielectric layer between the metal layers or (b) grow a conductive filament in the dielectric layer between the metal layers.

Memory operations directed to an RRAM cell include a read operation and three types of write operations: a forming operation, a programming operation (also referred to herein as a set operation), and an erasing operation (also referred to herein as a reset operation). The forming operation is an initial operation performed post-manufacture to condition the programmable resistor to be able to switch between a low resistance state (LRS) (through the programming operation) and a high resistance state (HRS) (through the erasing operation). Specifically, during a forming operation, the resistance state of the programmable resistor of a selected memory cell is switched from an initial very high resistance state (iHRS), as seen immediately after manufacturing, to an operational resistance state that is lower than the iHRS (e.g., to an operational high resistance state (HRS) or to an operational low resistance state (LRS)). Typically, the forming operation includes concurrently applying a high positive voltage to the WL connected to the selected memory cell, applying an even higher positive voltage to the BL connected to the selected memory cell, and discharging the SL connected to the selected memory to ground. The HRS can be used to store, for example, a logic "0" and the LRS can be used to store, for example, a logic "1." During a programming operation, the resistance state of the programmable resistor in a selected memory cell is switched from the HRS to the LRS (i.e., to store a logic "1"). Typically, the programming operation includes concurrently applying a high positive voltage to the WL connected to the selected memory cell (e.g., the same word line voltage as used during forming), applying a higher positive voltage to the BL connected to the selected memory cell (e.g., a lower bit line voltage than that used during forming but still higher than the word line voltage), and discharging the SL connected to the selected memory to ground. During an erasing operation, the resistance state of the programmable resistor in a selected bit cell is switched from the LRS to the HRS (i.e., to store a logic "0"). Typically, the erasing operation includes concurrently applying a high positive voltage to the WL connected to the selected memory cell (e.g., a word line voltage that is higher than the word line voltage used during forming), applying a higher positive voltage to the SL connected to the selected memory cell, and discharging the BL connected to the selected memory to ground.

As mentioned above, each memory cell 101 can further include an access transistor 103 (e.g., an n-type field effect transistor (NFET)). In some embodiments, access transistor 103 of each memory cell 101 can be a low voltage NFET, such as an NFET with a 0.8V rating. Programmable resistor 102 and access transistor 103 can be connected in series between a bit line (BL) 181 and a source line (SL) 182. Specifically, the programmable resistor 102 can have a first terminal connected to a BL 181 and a second terminal connected to a source/drain region of access transistor 103. Another source/drain region of access transistor 103 can be connected to a SL 182 and a gate of access transistor 103 can be connected to a word line (WL) 183. As discussed in greater detail below, SL 182 can be column-specific (e.g., as in memory structure 100A of FIG. 1A) or shared by adjacent memory cells 101 in adjacent columns (e.g., as in memory structure 100B of FIG. 1B). In some embodiments, memory structure 100A, 100B can be implemented in an advanced semiconductor-on-insulator technology node. For example, memory structure 100A, 100B could be implemented using a fully depleted silicon-on-insulator (FDSOI) processing technology or a partially depleted silicon-on-insulator (PDSOI) process technology. In this case, access transistor 103 can be an FDSOI NFET or a PDSOI NFET.

As illustrated in FIGs. 1A and 1B, memory cells 101 within array 110 can be arranged in columns and rows. Optionally, to be competitive in terms of area efficiency, array 110 can be relatively large. For example, array 110 may include 512 rows of memory cells 101 (e.g., see rows R₀-R₅₁₁) and 4864 columns of memory cells 101 (e.g., see columns C₀-C₄₈₆₃). It should be understood, however, that the numbers of columns and rows shown in FIGs. 1A and 1B are provided for illustration purposes and not intended to be limiting.

Memory structure 100A, 100B can further include bit lines (BLs) for the columns, respectively (e.g., see BLs 181₀-181₄₈₆₃ for columns C₀-C₄₈₆₃, respectively). All memory cells 101 in a column can be connected to the BL for that column. That is, the programmable resistors 102 of all memory cells 101 in the same column can be connected between the access transistors 103 of those memory cells 101 and the BL for the column. Optionally, the BLs can be grouped together sequentially in BL groups (BLGs). For purposes of illustration, BLs 181₀-181₄₈₆₃ are illustrated as being grouped together sequentially into one hundred and fifty-two groups each having thirty-two BLs (e.g., see BLG₀ including BLs 181₀ for C₀ to 181₃₁ for C₃₁; ..., and BLG₁₅₁ including BLs 181₄₈₃₁ for C₄₈₃₁ to 181₄₈₆₃ for C₄₈₆₃). These BLGs may correspond to different I/O of a memory.

Memory structure 100A, 100B can further include peripheral circuitry connected to the BLs to facilitate operation-dependent selective BL biasing. For example, memory structure 100A, 100B can include BL multiplexers (BL MUXs) for each of the BLGs (e.g., see BL MUXs 145₀-145₁₅₁ for BLG₀-BLG₁₅₁, respectively) with all BLs in any particular BLG being connected to the BL MUX for that particular BLG. For purposes of illustration, FIGs. 1A and 1B show embodiments where nodes at the ends of the BLs in BLG₀-BLG₁₅₁ are electrically connected to BL MUXs 145₀-145_{151,} respectively. However, it should be understood that the figures are not intended to be limiting. In alternative embodiments other nodes on the BLs (e.g., nodes at the center of each BL) in BLG₀-BLG₁₅₁ could be electrically connected to BL MUXs 145₀-145₁₅₁, respectively. Additionally, BL drivers 141₀-141₁₅₁ connected to BL MUXs 145₀-145₁₅₁, respectively. Each BL MUX 145₀-145₁₅₁ and corresponding BL driver 141₀-141₁₅₁ can, in combination, be configured to selectively bias the BLs of the BLG in response to control signals from a memory controller (not shown). Those skilled in the art will recognize that the voltage levels of the bit line voltages (VBLs) used to bias the BLs within memory structure 100A, 100B will depend on various factors including, but not limited to, the type of memory operation being performed in a selected memory cell (e.g., such as forming, programming, erasing, or reading in an RRAM cell) and whether a BL is connected to the selected memory cell. Examples of such VBLs are discussed in greater detail below regarding the disclosed operating method embodiments. In any case, BL MUXs and BL drivers, which are employed in NVM structures, such as RRAM structures, and which operate in response to control signals from a memory controller are known in the art. Thus, the details thereof have been omitted from the specification in order to allow the reader to focus on the salient aspects of the disclosed embodiments.

Memory structure 100A, 100B can further include word lines (WLs) for the rows, respectively (e.g., see WLs 183₀-183₅₁₁ for rows R₀-R_{511,} respectively). All memory cells 101 in a row can be connected to the WL for that row. That is, the gates of all access transistors 103 of all memory cells 101 in the same row can be connected to the WL for that row. Optionally, the WLs can be grouped together sequentially in WL groups (WLGs). For purposes of illustration, WLs 183₀-183₅₁₁ are illustrated as being grouped together sequentially in four groups each with one hundred and twenty-eight WLs (e.g., see WLGₐ including WLs 183₀ for R₀ to 183₁₂₇ for R₁₂₇, WLG₁ including WLs 183₁₂₈ for R₁₂₈ to 183₂₅₅ for R₂₅₅, WLG_{c} including WLs 183₂₅₆ for R₂₅₆ to 183₃₈₃ for R₃₈₃, and WLGₐ including WLs 183₃₈₄ for R₃₈₄ to 183₅₁₁ for R₅₁₁).

Memory structure 100A, 100B can further include peripheral circuitry connected to the WLs to facilitate operation-dependent WL biasing. For example, memory structure 100A, 100B can further include a WL multiplexer (WL MUX) 125 connected to all WLs for all WLGs and a WL driver 121 connected to the WL MUX 125, respectively. WL MUX 125 and WL driver 121 can, in combination, be configurated to selectively bias a selected WL in response to control signals from a memory controller (not shown). Those skilled in the art will recognize that the voltage levels of the word line voltages (VWLs) used to bias the WLs within memory structure 100A, 100B will depend on various factors including, but not limited to, the type of memory operation being performed in a selected memory cell (e.g., such as forming, programming, erasing, or reading in an RRAM cell) and whether a WL is connected to the selected memory cell. Examples of such VWLs are discussed in greater detail below regarding the disclosed operating method embodiments. In any case, WL MUXs and WL drivers, which are employed in NVM structures, such as RRAM structures, and which operate in response to control signals from a memory controller are known in the art. Thus, the details thereof have been omitted from the specification in order to allow the reader to focus on the salient aspects of the disclosed embodiments.

Memory structure 100A, 100B can further include source lines (SLs). However, instead of all memory cells in a column being connected to the same SL as in conventional NVM structures, in the disclosed embodiments the memory cells of different sections (and particularly sequential sections) of the same column are connected to different SL, respectively.

In some embodiments, as illustrated in the memory structure 100A of FIG. 1A, each set of SLs for each column can be column-specific. For example, memory cells in sequential sections of C₀ can be connected to SLs 182₀ₐ-182_{0d}, respectively; memory cells in sequential sections of C₁ can be connected to SLs 182₁ₐ-182_{1d}, respectively, ... and, memory cells in sequential sections of C₄₈₆₃ can be connected to SLs 182₄₈₆₃ₐ-182_{4863d}, respectively.

In other embodiments, as illustrated in the memory structure 100B of FIG. 1B, each set of SLs can be shared by two adjacent columns to reduce area consumption. For example, memory cells in sequential sections of C₀ and of C₁ (which are adjacent to each other) can be connected to shared SLs 182₀ₐ₋₁ₐ-182_{0d-1d}, respectively; memory cells in sequential sections of C₂ and of C₃ (which are adjacent to each other) can be connected to shared SLs 182₂ₐ₋₃ₐ-182_{2d-3d}, respectively, ... and, memory cells in sequential sections of C₄₈₆₂ and of C₄₈₆₃ (which are adjacent to each other) can be connected to shared SLs 182₄₈₆₂ₐ₋₄₈₆₃ₐ-182_{4862d-4863d}, respectively.

Optionally, each SL and sequential section of a column connected to the SL can correspond to a WLG. That is, memory cells within the same column and connected to the WLs of a given WLG will also be connected to the same SL for that column. For purposes of illustration, FIGs. 1A-1B show four different WLGs (e.g., WLGₐ-WLG_{d}) and, thus, four different SLs for each column. However, as mentioned above, the figures are not intended to be limiting. Altemative embodiments could include any number of two or more WLGs and the same number of two or more SLs for each column.

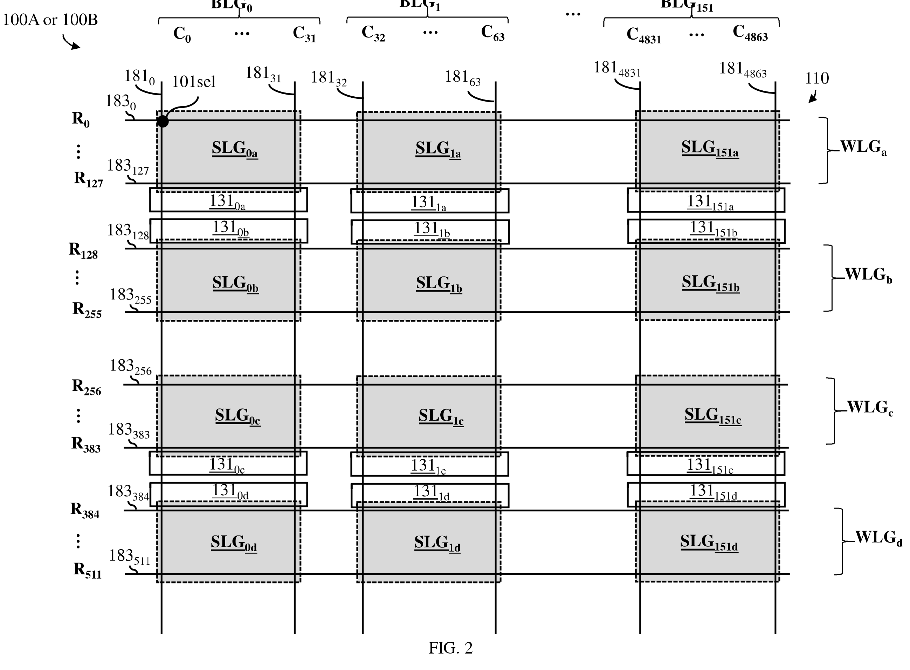

Also, optionally, the various SLs in memory structure 100A, 100B can be grouped together in SL groups (SLGs) such that each SLG includes all SLs within an intersecting area between one BLG and one WLG, as highlighted in the plan diagram for memory structure 100A or 100B shown in FIG. 2. For example, as illustrated in FIG. 2 in combination with FIGs. 1A and 1B, SLG₀ₐ can include all SLs located in the intersecting area between BLG₀ and WLGₐ, SLG_{0b} includes all SLs located in the intersecting area between BLG₀ and WLG_{b}, SLG_{0c} includes all SLs located in the intersecting area between BLG₀ and WLG_{c}, SLG_{0d} includes all SLs located in the intersecting area between BLG₀ and WLG_{d},..., and SLG₁₅₁ₐ includes all SLs located in the intersecting area between BLG₁₅₁ and WLGₐ, SLG_{151b} includes all SLs located in the intersecting area between BLG₁₅₁ and WLG_{b}, SLG_{151c} includes all SLs located in the intersecting area between BLG₁₅₁ and WLG_{c}, SLG_{151d} includes all SLs located in the intersecting area between BLG₁₅₁ and WLG_{d}. For purposes of this disclosure, the intersecting area between a particular BLG and a particular WLG refers to an area of the array that includes only those memory cell that are located both within the columns connected to the BLs of the particular BLG and within the rows connected to the WLs with the particular WLG.

Memory structure 100A, 100B can further include peripheral circuitry connected to the SLs to facilitate operation-dependent SL biasing.

For example, memory structure 100A, 100B could include SL drivers 131₀ₐ-131_{151d} connected to the SLs of the SLG₀ₐ-SLG_{151d}, respectively. Each SL driver 131₀ₐ-131_{151d} can be configured to concurrently bias all SLs in a corresponding SLG₀ₐ-SLG₁₅₁ₐ at the same voltage level (i.e., with the same source line voltage (VSL)). Each SL driver 131₀ₐ-131_{151d} can be independently operable so that the SLs in different SLGs can be biased differently (i.e., biased with source line voltages (VSLs) at different source line voltage levels). The voltage level of the source line voltage (VSL) output by any given SL driver 131₀ₐ-131_{151d} to the SLs of its corresponding SLG₀ₐ-SLG_{151d} can depend on various factors including, but not limited to, the type of memory operation being performed in a selected memory cell (e.g., such as forming, programming, erasing, or reading in an RRAM cell) and also on the location of the selected memory cell. For example, the voltage level of a VSL output by a SL driver to its corresponding SLG can depend on: (a) whether the SLG is the specific SLG that contains the SL connected to the selected memory cell; (b) whether the SLG intersects the same BLG as that specific SLG but not the same WLG; (c) whether the SLG intersects the same WLG as that specific SLG but not the same BLG; and (d) whether the SLG intersects neither the same BLG nor the same WLG as that specific SLG. It should be noted that, since individual SLs within the SLGs are not selectively biased in the illustrated embodiments, SL MUXs are not connected between the SL drivers and the SLs and area consumption is limited.

However, it should be understood that the figures are not intended to be limiting. In alternative embodiments (not shown), memory structure 100A, 100B could include SL MUXs connected to between the SLs of each SLG₀ₐ-SLG_{151d} and SL drivers 131₀ₐ-131_{151d}, respectively. While incorporating SL MUXs would increase the area requirement for the memory structure, inclusion of such SL MUX would enable selective biasing of individual SLs within any SLG for some applications.

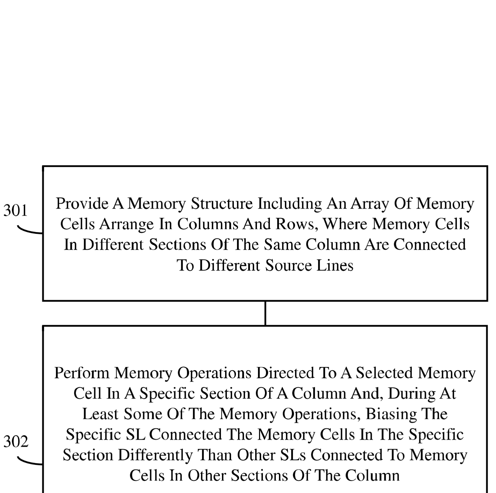

Also disclosed herein are embodiments of an associated memory structure operating method. Referring to the flow diagram of FIGs. 3A-3D, generally embodiments of the disclosed method can include providing a memory structure (e.g., memory structure 100A of FIG. 1A or memory structure 100B of FIG. 1B, as described in detail above) (see process 301). Embodiments of the disclosed method can also include performing memory operations directed to a selected memory cell 101 in memory structure 100A, 100B (see process 302). Furthermore, given the configuration of memory structure 100A, 100B, at least some of the memory operations performed at process 302 can include biasing a specific SL (which is connected to all memory cells in the specific section of the column that contains the selected memory cell) differently than all other SLs connected to all other memory cells in all other sections of that same column.

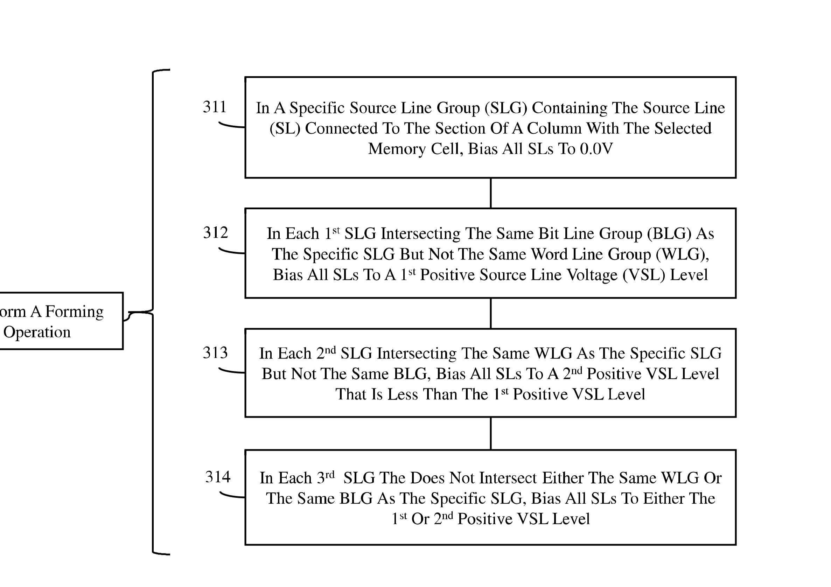

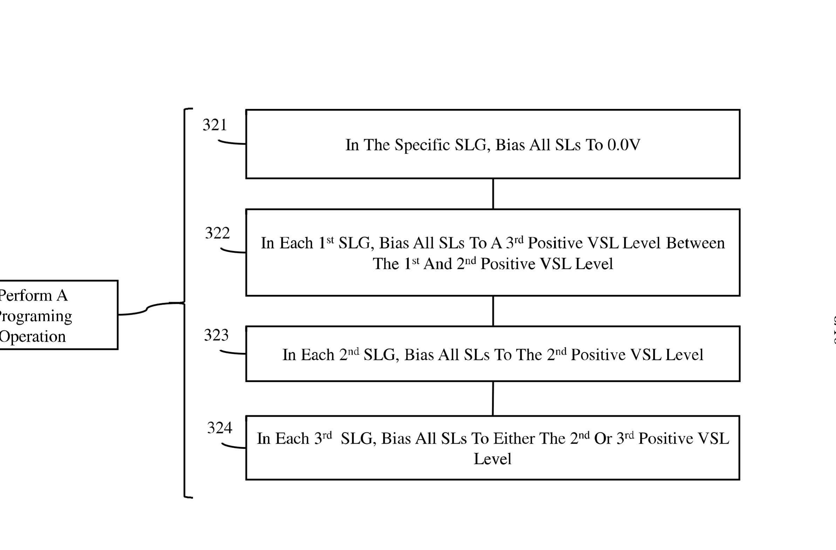

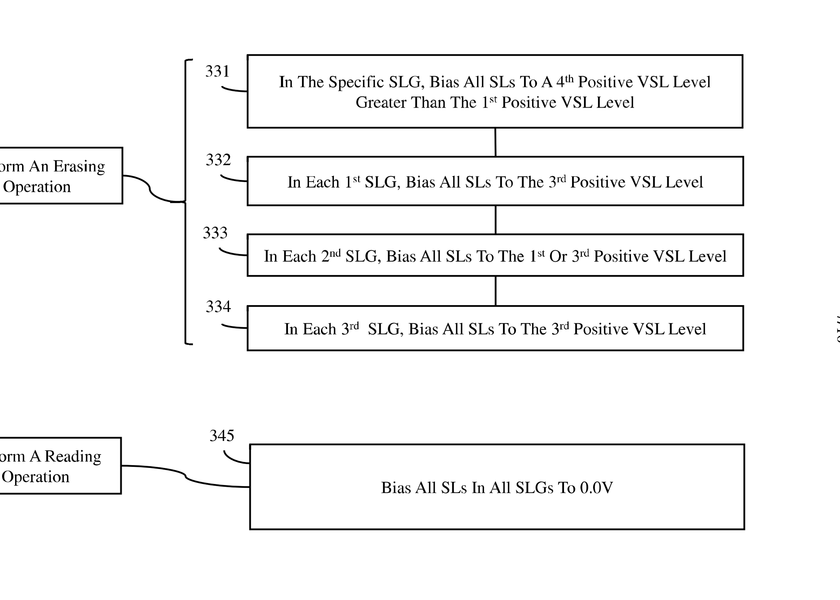

For purposes of illustration, process 302 is described in greater detail below and illustrated in FIGs. 3B-3D regarding embodiments where the memory structure 100A, 100B is specifically an RRAM structure with RRAM cells including low voltage access transistors (e.g., access transistors 103 having a 0.8V rating), where the selected memory cell 101sel is located at the intersection of C₀ and R₀ (e.g., as indicated in FIG. 2), and where the memory operations can include any of a forming operation (see process 310 and FIG. 3B), a programming operation (see process 320 and FIG. 3C), an erasing operation (see process 330 and FIG. 3D), and a reading operation (see process 340 and FIG. 3D). In this case, the selected memory cell 101sel can be connected to BL 181₀, WL 183₀ and SL 182₀ₐ (in the case of memory structure 100A of FIG. 1A) or SL 182₀ₐ₋₁ₐ (in the case of memory structure 100B of FIG. 1B). Thus, the specific SLG that contains the SL 182₀ₐ (or if applicable SL 182₀ₐ₋₁ₐ) connected to the selected memory cell is SLG₀ₐ. First SLGs, which intersect the same BLG₀ as SLG₀ₐ but different WLGs include SLG_{0b}-SLG_{0d}. Second SLGs, which intersect the same WLGₐ as SLG₀ₐ but different BLGs include SLG₁ₐ-SLG₁₅₁ₐ. Third SLGs, which do not intersect either same BLG₀ or the same WLGₐ as SLG₀ₐ, include SLG_{1b}-SLG_{1d}, and so on to SLG_{151b}-SLG_{151d}.

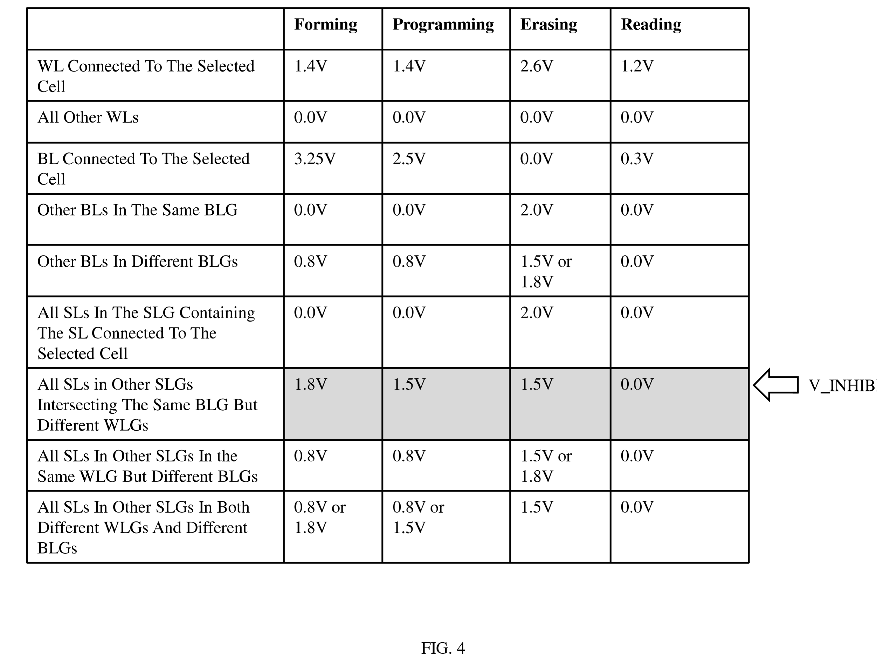

FIG. 4 is a table illustrating examples of biasing conditions that can be employed in memory structure 100A, 100B for each of the different memory operations (e.g., the forming operation at process 310, the programming operation at process 320, the erasing operation at process 330, and the reading operation at process 340).

Referring to FIGs. 1A-1B, 2, 3A-3D, and 4 in combination examples of techniques for performing forming, programming, erasing, and reading operations are described in greater detail below.

The forming operation at process 310 (see FIG. 3B) can include selectively biasing the WL 183₀ (which is connected to the selected memory cell 101sel) to a first positive word line voltage (VWL) level. This first positive VWL level can be higher than the voltage rating (e.g., of 0.8V) of the access transistors 103 within the memory cells 101 of the memory structure 100A, 100B. For example, in some embodiments, the first positive VWL level can be approximately 1.4V. All other WLs can be biased to 0.0Vs.

The forming operation at process 310 can include selectively biasing the BL 181₀ (which is connected to the selected memory cell 101sel) to a first positive bit line voltage (VBL) level. This first positive VBL level can be relatively high and significantly higher than the first positive VWL level (e.g., of 1.4V). For example, in some embodiments, the first positive VBL level can be approximately 3.25V. All other BLs in the same BLG₀ can be biased to 0.0Vs. The BLs in all other BLGs (e.g., BLG₁ to BLG₁₅₁) can be biased to a second positive VBL level that is less than the first positive VBL level (e.g., of 1.8V). For example, in some embodiments, the second positive VBL level can be at 0.8V.

The forming operation at process 310 can further include biasing all SLs in the specific SLG₀ₐ, which contains SL 182₀ₐ (in the case of memory structure 100A of FIG. 1A) or SL 182₀ₐ₋₁ₐ (in the case of memory structure 100B of FIG. 1B) connected to the selected memory cell 101sel, differently than all other SLs in all other SLGs (e.g., SLG_{0b}-SLG_{151d}). More specifically, the forming operation can include concurrently biasing all SLs in SLG₀ₐ (which contains the SL connected to the selected memory cell 101sel) to 0.0V (see process 311). It can further include concurrently biasing all SLs in SLG_{0b}-SLG_{0d} (which intersect the same BLG₀ as SLG₀ₐ but different WLGs) to a first positive source line voltage (VSL) level (see process 312). The first positive VSL level can be relatively high (but still lower than the first positive VBL level (e.g., of 3.25V). For example, in some embodiments, the first positive VSL level can be at 1.8V. The forming operation can further include concurrently biasing all SLs in SLG₁ₐ-SLG₁₅₁ (which intersect the same WLG₀ as SLG₀ₐ but different BLGs) to a second VSL level (see process 313). The second positive VSL level can be relatively low and, particularly, lower than the first positive VSL level (e.g., of 1.8V). For example, in some embodiments, the second positive VSL level can be at 0.8V. The forming operation can further include concurrently biasing all SLs in SLG_{1b}-SLG_{1d}, and so on to SLG_{151b}-SLG_{151d} (which do not intersect either the same WLG₀ or the BLG₀ as SLG₀ₐ) either to the first positive VSL level (e.g., to 1.8V) or to the second positive VSL level (e.g., to 0.8V) (see process 314).

The programming operation at process 320 (see FIG. 3C) can include selectively biasing the WL 183₀ (which is connected to the selected memory cell 101sel) to the first positive VWL level (e.g., to 1.4V). All other WLs can be biased to 0.0Vs.

The programming operation at process 320 can further include selectively biasing the BL 181₀ (which is connected to the selected memory cell 101sel) to a third positive VBL level. This third positive VBL level can be relatively high and, more particularly, higher than the second positive VBL level (e.g., of 0.8V) but lower than the first positive VBL level (e.g., of 3.25V). For example, in some embodiments, the third positive VBL level can be approximately 2.5V. All other BLs in the same BLG₀ can be biased to 0.0Vs. The BLs in all other BLGs (e.g., BLG₁ to BLG₁₅₁) can be biased to the second positive VBL level (e.g., to 0.8V).

The programming operation at process 320 can further include biasing all SLs in the specific SLG₀ₐ, which contains SL 182₀ₐ (in the case of memory structure 100A of FIG. 1A) or SL 182₀ₐ₋₁ₐ (in the case of memory structure 100B of FIG. 1B) connected to the selected memory cell 101sel, differently than all other SLs in all other SLGs (e.g., SLG_{0b}-SLG_{151d}). More specifically, the programming operation can include concurrently biasing all SLs in SLG₀ₐ (which contains the SL connected to the selected memory cell 101sel) to 0.0V (see process 321). It can further include concurrently biasing all SLs in SLG_{0b}-SLG_{0d} (which intersect the same BLG₀ as SLG₀ₐ but different WLGs) to a third positive VSL level (see process 322). The third positive VSL level can be relatively high (but lower than the first positive VSL level of, for example, 1.8V). For example, in some embodiments, the third positive VSL level can be at 1.5V. The programming operation can further include concurrently biasing all SLs in SLG₁ₐ-SLG₁₅₁ (which intersect the same WLG₀ as SLG₀ₐ but different BLGs) to the second positive VSL level (e.g., 0.8V) (see process 323). The programming operation can further include concurrently biasing all SLs in SLG_{1b}-SLG_{1d}, and so on to SLG_{151b}-SLG_{151d} (which do not intersect either the same WLG₀ or the BLG₀ as SLG₀ₐ) either to the third positive VSL level (e.g., to 1.5V) or to the second positive VSL level (e.g., to 0.8V) (see process 324).

The erasing operation at process 330 (see FIG. 3D) can include selectively biasing the WL 183₀ (which is connected to the selected memory cell 101sel) to a second positive VWL level. The second positive VWL level can be relatively high compared to the first positive VWL level (e.g., of 1.4V). For example, in some embodiments, the second positive VWL level can be at 2.6V. All other WLs can be biased to 0.0Vs.

The erasing operation at process 330 can further include selectively biasing the BL 181₀ (which is connected to the selected memory cell 101sel) to 0.0V and biasing all other BLs in the same BLG₀ to a fourth positive VBL level. This fourth positive VBL level can be between the second positive VBL level (e.g., of 0.8V) and the third positive VBL level (e.g., of 2.5V). For example, in some embodiments, the fourth positive VBL level can be approximately 2.0V. The BLs in all other BLGs (e.g., BLG₁ to BLG₁₅₁) can be biased to a fifth positive VBL level, which is lower than the fourth positive VBL level. For example, in some embodiments, the fifth VBL level can be 1.5V or 1.8V.

The erasing operation at process 330 can further include biasing all SLs in the specific SLG₀ₐ, which contains SL 182₀ₐ (in the case of memory structure 100A of FIG. 1A) or SL 182₀ₐ₋₁ₐ (in the case of memory structure 100B of FIG. 1B) connected to the selected memory cell 101sel, differently than all other SLs in all other SLGs (e.g., SLG_{0b}-SLG_{151d}). More specifically, the erasing operation can include concurrently biasing all SLs in SLG₀ₐ (which contains the SL connected to the selected memory cell 101sel) to a fourth positive VSL level (see process 331). The fourth positive VSL level can be greater than the first positive VSL level. For example, in some embodiments, the fourth positive VSL level can be 2.0V. The erasing operation can further include concurrently biasing all SLs in SLG_{0b}-SLG_{0d} (which intersect the same BLG₀ as SLG₀ₐ but different WLGs) to the third positive VSL level (e.g., to 1.5V) (see process 332). The erasing operation can further include concurrently biasing all SLs in SLG₁ₐ-SLG₁₅₁ₐ (which intersect the same WLG₀ as SLG₀ₐ but different BLGs) either to the third positive VSL level (e.g., to 1.5V) or to the first positive VSL level (e.g., to 1.8V) (see process 333). The erasing operation can further include concurrently biasing all SLs in SLG_{1b}-SLG_{1d}, and so on to SLG_{151b}-SLG_{151d} (which do not intersect either the same WLG₀ or the BLG₀ as SLG₀ₐ) to the third positive VSL level (e.g., 1.5V) (see process 334).

The reading operation at process 340 (see also FIG. 3D) can include selectively biasing the WL 183₀ (which is connected to the selected memory cell 101sel) to a third positive VWL level. The third positive VWL can be less than the first positive VWL (e.g., of 1.4V). For example, in some embodiments the third positive VWL can be at 1.2V. All other WLs can be biased to 0.0Vs. The reading operation at process 340 can further include selectively biasing the BL 181₀ (which is connected to the selected memory cell 101sel) to a sixth positive VBL level. This sixth positive VBL level can be relatively low and, more particularly, significantly lower than the second positive VBL level (e.g., of 0.8V). For example, in some embodiments, the sixth positive VBL level can be approximately 0.3V. All other BLs in the same BLG₀ and any other BLGs can be biased to 0.0Vs. Additionally, during this reading operation at process 340, all SLs in all SLGs can be biased to 0.0V (see process 345).

Thus, with the BL, SL, and WL biasing levels employed during the various memory operations (as described above and illustrated in the table of FIG. 4), BL-SL leakage current through at least some unselected memory cells (particularly during high voltage memory operations) is limited and, thus, any operation-dependent reduction in life expectancy of memory cell transistors (e.g., due to TDDB) is also limited.

Consider the example biasing conditions discussed above and illustrated in FIG. 4 for memory operations directed to a selected memory cell 101sel in R₀ and C₀. In a conventional memory structure that includes a single SL connected to all memory cells in the same column, there will be large voltage differential between the BL and SL connected to unselected memory cells (i.e., memory cells where the access transistor is in an off-state, for example, due to 0.0V WL biasing). However, when there is a high voltage differential between the BL and the SL connected to any unselected memory cell (e.g., if the BL is at a high positive voltage and the SL is at 0.0V or vice versa), BL-SL leakage can occur. By employing multiple SLs for different sections of each column, any unselected cell connected to the same SL as the selected memory cell may experience leakage. However, the SLs connected to unselected memory cells in different sections of the same column can be positively biased in order to reduce the voltage differential between the BL and the SL and thereby limit BL-SL leakage through at least some unselected memory cells.

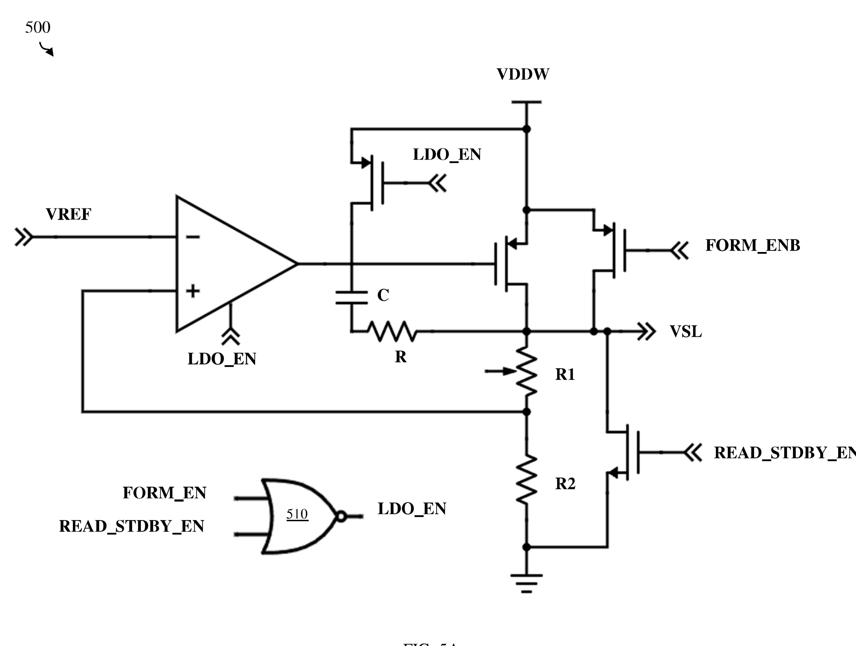

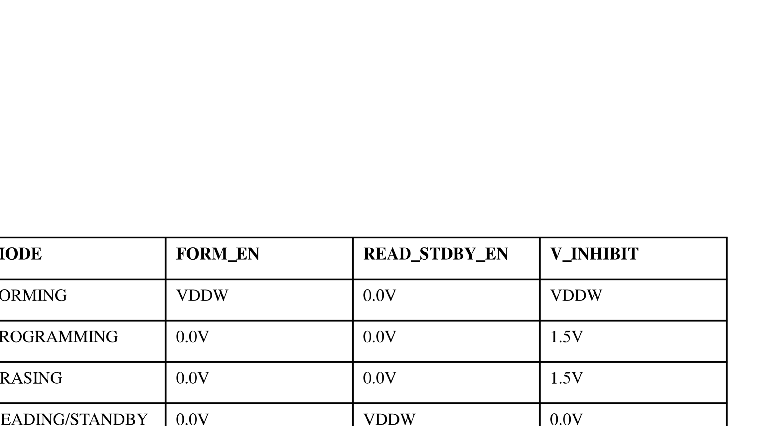

FIG. 5A is a schematic diagram illustrating one example of a source line voltage generation circuit 500, which can be incorporated into memory structure 100A, 100B, which can be connected to one or more SL drivers 131₀ₐ-131_{151d}, and which can, in response to control signals from a controller, generate and output an operation-dependent source line voltage (VSL). Each SL driver connected to the source line voltage generation circuit 500 can receive an operation-dependent VSL and apply it to all SLs within the corresponding SLG. For example, in some embodiments, the source line voltage generation circuit 500 can be connected to each of the SL drivers and the SL can be selectively driven to the voltage provided. In this example, source line voltage generation circuit 500 can be a low drop out (LDO) voltage regulator. Control signals from the controller can, for example, include a forming mode enable signal (FORM_EN), and a read/standby mode enable signal (READ_STDBY_EN). As illustrated, source line voltage generator 500 can include a not OR (NOR) gate 510, which receives as inputs FORM_EN and READ_STDBY_EN, and outputs a LDO regulator enable signal (LDO_EN) according to a conventional NOR truth table. That is, when FORM_EN and READ_STDBY_EN are both low, LDO_EN will be high. When FORM_EN and READ_STDBY_EN are either both high or different, LDO_EN will be low. Depending upon the states of FORM _EN and READ_STDBY_EN, the output VSL will vary. FIG. 5B is a table illustrating examples of different operation-dependent states of the above-mentioned control signals (FORM_EN and READ_STDBY_EN) and the resulting output VSL.

It should be understood that in the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a memory structure and associated operating method are disclosed in various embodiments. The structure includes: an array of memory cells in columns and rows; and, for each column, a bit line (BL) and multiple source lines (SLs). The BL is connected to all memory cells in the column, whereas each SL is connected to all memory cells in a corresponding section of the column. During a memory operation directed to a selected memory cell within a column, the SL connected to the selected memory cell and to all unselected memory cells within the same section of the column can be biased to an operation-dependent source line voltage level and the SLs connected to the unselected memory cells in all other sections of the same column can be biased to a different source line voltage level to minimize leakage current through at least some unselected memory cells.
The following embodiments are explicitly disclosed.
Embodiment 1:
   A structure comprising:
   an array of memory cells in columns and rows; and
   for each column of the memory cells in the array:
      a bit line for the column, wherein the bit line is connected to all memory cells in the column; and
      source lines for different sections of the column, wherein each source line is connected to all memory cells in a corresponding section of the column.
Embodiment 2: The structure of embodiment 1, wherein the different source lines for the different sections of the column are column-specific.
Embodiment 3:
   The structure of embodiment 1 or 2, wherein the different source lines for the different sections of the column are shared between two adjacent columns.
Embodiment 4:
   The structure of one of embodiments 1 to 3, further comprising:
   bit lines for the columns; and
   word lines for the rows,
   wherein, for each row of the memory cells in the array, a word line for the row is connected to all memory cells in the row, and
   wherein the bit lines are grouped sequentially in bit line groups, the word lines are grouped sequentially in word line groups, and the source lines are grouped in source line groups such that each source line group includes all source lines within an intersecting area between one bit line group and one word line group.
Embodiment 5:
   The structure of embodiment 4, further comprising: bit line multiplexers for the bit line groups; and bit line drivers connected to the bit line multiplexers, respectively, to enable independent biasing of any bit line within any bit line group.
Embodiment 6:
   The structure of one of embodiments 1 to 5, further comprising source line drivers for the source line groups, respectively, wherein each source line driver for a source line group concurrently biases all source lines within the source line group to a same source line voltage level.
Embodiment 7:
   The structure of embodiment 6, further comprising a source line voltage generation circuit, wherein the source line driver is connected to receive an operation-dependent source line voltage from the source line voltage generation circuit and further outputs the operation-dependent source line voltage to the source lines within the source line group.
Embodiment 8:
   The structure of embodiment 6 or 7, wherein each source line driver is independently operable to enable biasing of the source lines within different source line groups to different source line voltage levels, respectively.
   In some special illustrative examples herein, each source line driver may be independently operable to enable biasing of the source lines within different source line groups with different source line voltages to different source line voltage levels, respectively
Embodiment 9:
   The structure of one of embodiments 1 to 8, wherein the memory cells include resistive random access memory cells
Embodiment 10:
   A structure comprising:
   an array of memory cells in columns and rows, wherein the memory cells include resistive random access memory cells; and
   for each column of the memory cells in the array:
      a bit line for the column, wherein the bit line is connected to all memory cells in the column; and
      source lines for different sections of the column, wherein each source line is connected to all memory cells in a corresponding section of the column.
Embodiment 11:
   The structure of embodiment 9 or 10, further comprising:
   bit lines for the columns; and
   word lines for the rows,
   wherein, for each row of the memory cells in the array, a word line for the row is connected to all memory cells in the row, and
   wherein the bit lines are grouped sequentially in bit line groups, the word lines are grouped sequentially in word line groups, and the source lines are grouped in source line groups such that each source line group includes all source lines within an intersecting area between one bit line group and one word line group.
Embodiment 12:
   The structure of embodiment 11, further comprising: bit line multiplexers for the bit line groups; and bit line drivers connected to the bit line multiplexers, respectively, to enable independent biasing of any bit line within any bit line group.
Embodiment 13:
   The structure of one of embodiments 9 to 12, further comprising source line drivers for the source line groups, respectively, wherein each source line driver for a source line group concurrently biases all sources lines within the source line group to a same source line voltage level.
Embodiment 14:
   The structure of embodiment 13, further comprising a source line voltage generation circuit, wherein the source line driver is connected to receive an operation-dependent source line voltage from the source line voltage generation circuit and further outputs the operation-dependent source line voltage to the source lines within the source line group.
Embodiment 15:
   The structure of embodiment 13 or 14, wherein each source line driver is independently operable to enable biasing of the source lines within different source line groups with different source line voltages to different source line voltage levels, respectively.
Embodiment 16:
   The structure of one of embodiments 1 to 15, wherein the structure is a memory structure.
Embodiment 17:
   A method including comprising:
   providing a memory structure (e.g., the structure of one of embodiments 1 to 16) including: an array of memory cells in columns and rows; and, for each column of the memory cells in the array: a bit line for the column, wherein the bit line is connected to all memory cells in the column; and source lines for different sections of the column, wherein each source line is connected to all memory cells in a corresponding section of the column; and
   performing a memory operation directed to a selected memory cell in the column, wherein the performing of the memory operation includes biasing a source line for a section of the column that contains the selected memory cell differently than other source lines for other sections of the column.
Embodiment 18:
   The method of embodiment 17,
   wherein the memory structure further includes: bit lines for the columns and word lines for the rows,
   wherein, for each row of the memory cells in the array, a word line for the row is connected to all memory cells in the row, and
   wherein the bit lines are grouped sequentially in bit line groups, the word lines are grouped sequentially in word line groups, and the source lines are grouped in source line groups such that each source line group includes all source lines within an intersecting area between one bit line group and one word line group.
Embodiment 19:
   The method of embodiment 18, wherein the memory operation includes a forming operation including:
   concurrently biasing all source lines in a specific source line group to 0.0 volts (V), wherein the specific source line group includes the source line for the section of the column that contains the selected memory cell;
   concurrently biasing all source lines in first source line groups to a first positive source line voltage level, which each first source line group intersect a same bit line group as the specific source line group and a different word line group than the specific source line group;
   concurrently biasing all source lines in second source line groups to a second positive source line voltage level that is less than the first positive source line voltage level, wherein each second source line group intersects a same word line group as the specific source line group and a different bit line group than the specific source line group, at; and
   concurrently biasing all source lines in third source line groups to one of the first positive source line voltage level and the second positive source line voltage level, wherein each third source line group intersects both different bit line and source line groups than the specific source line group.
Embodiment 20:
   The method of embodiment 19, wherein the memory operation includes a programming operation including:
   concurrently biasing the source lines in the specific source line group to 0.0V;
   concurrently biasing the source lines in the first source line groups to a third positive source line voltage level that is between the first positive source line voltage level and the second positive source line voltage level;
   concurrently biasing the source lines in the second source line groups to the second positive source line voltage level; and
   concurrently biasing the source lines in the third source line groups to one of the third positive source line voltage level and the second positive source line voltage level.
Embodiment 21:
   The method of embodiment 20, wherein the memory operation includes an erasing operation including:
   concurrently biasing the source lines in the specific source line group to a fourth positive source line voltage level that is greater than the first positive source line voltage level;
   concurrently biasing the source lines in the first source line groups to the third positive source line voltage level;
   concurrently biasing the source lines in the second source line groups to one of the first positive source line voltage level and the third positive source line voltage level; and
   concurrently biasing the source lines in the third source line groups to the third positive source line voltage level.
Embodiment 22:
   The method of one of embodiments 18 to 21, wherein the memory operation includes a reading operation including: concurrently biasing all source lines in all source line groups to 0.0V.

## Claims

1. A structure comprising:
an array of memory cells in columns and rows; and
for each column of the memory cells in the array:
a bit line for the column, wherein the bit line is connected to all memory cells in the column; and
source lines for different sections of the column, wherein each source line is connected to all memory cells in a corresponding section of the column.

2. The structure of claim 1, wherein the different source lines for the different sections of the column are column-specific.

3. The structure of claim 1 or 2, wherein the different source lines for the different sections of the column are shared between two adjacent columns.

4. The structure of one of claims 1 to 3, further comprising:
bit lines for the columns; and
word lines for the rows,
wherein, for each row of the memory cells in the array, a word line for the row is connected to all memory cells in the row, and
wherein the bit lines are grouped sequentially in bit line groups, the word lines are grouped sequentially in word line groups, and the source lines are grouped in source line groups such that each source line group includes all source lines within an intersecting area between one bit line group and one word line group.

5. The structure of claim 4, further comprising source line drivers for the source line groups, respectively, wherein each source line driver for a source line group concurrently biases all source lines within the source line group to a same source line voltage level.

6. The structure of claim 5, further comprising a source line voltage generation circuit, wherein the source line driver is connected to receive an operation-dependent source line voltage from the source line voltage generation circuit and further outputs the operation-dependent source line voltage to the source lines within the source line group.

7. The structure of claim 5 or 6, wherein each source line driver is independently operable to enable biasing of the source lines within different source line groups to different source line voltage levels, respectively, preferably each source line driver being independently operable to enable biasing of the source lines within different source line groups with different source line voltages to different source line voltage levels, respectively.

8. The structure of one of claims 4 to 7, further comprising: bit line multiplexers for the bit line groups; and bit line drivers connected to the bit line multiplexers, respectively, to enable independent biasing of any bit line within any bit line group.

9. The structure of one of claims 1 to 8, wherein the memory cells include resistive random access memory cells.

10. A method including comprising:
providing a memory structure including: an array of memory cells in columns and rows; and, for each column of the memory cells in the array: a bit line for the column, wherein the bit line is connected to all memory cells in the column; and source lines for different sections of the column, wherein each source line is connected to all memory cells in a corresponding section of the column; and
performing a memory operation directed to a selected memory cell in the column, wherein the performing of the memory operation includes biasing a source line for a section of the column that contains the selected memory cell differently than other source lines for other sections of the column.

11. The method of claim 10,
wherein the memory structure further includes: bit lines for the columns and word lines for the rows,
wherein, for each row of the memory cells in the array, a word line for the row is connected to all memory cells in the row, and
wherein the bit lines are grouped sequentially in bit line groups, the word lines are grouped sequentially in word line groups, and the source lines are grouped in source line groups such that each source line group includes all source lines within an intersecting area between one bit line group and one word line group.

12. The method of claim **11,** wherein the memory operation includes a forming operation including:
concurrently biasing all source lines in a specific source line group to 0.0 volts (V), wherein the specific source line group includes the source line for the section of the column that contains the selected memory cell;
concurrently biasing all source lines in first source line groups to a first positive source line voltage level, which each first source line group intersect a same bit line group as the specific source line group and a different word line group than the specific source line group;
concurrently biasing all source lines in second source line groups to a second positive source line voltage level that is less than the first positive source line voltage level, wherein each second source line group intersects a same word line group as the specific source line group and a different bit line group than the specific source line group, at; and
concurrently biasing all source lines in third source line groups to one of the first positive source line voltage level and the second positive source line voltage level, wherein each third source line group intersects both different bit line and source line groups than the specific source line group.

13. The method of claim 12, wherein the memory operation includes a programming operation including:
concurrently biasing the source lines in the specific source line group to 0.0V;
concurrently biasing the source lines in the first source line groups to a third positive source line voltage level that is between the first positive source line voltage level and the second positive source line voltage level;
concurrently biasing the source lines in the second source line groups to the second positive source line voltage level; and
concurrently biasing the source lines in the third source line groups to one of the third positive source line voltage level and the second positive source line voltage level.

14. The method of claim 13, wherein the memory operation includes an erasing operation including:
concurrently biasing the source lines in the specific source line group to a fourth positive source line voltage level that is greater than the first positive source line voltage level;
concurrently biasing the source lines in the first source line groups to the third positive source line voltage level;
concurrently biasing the source lines in the second source line groups to one of the first positive source line voltage level and the third positive source line voltage level; and
concurrently biasing the source lines in the third source line groups to the third positive source line voltage level.

15. The method of one of claims 11 to 14, wherein the memory operation includes a reading operation including: concurrently biasing all source lines in all source line groups to 0.0V.
